# EUROPEAN PATENT APPLICATION

(11) **EP 1 560 231 A2**
(43) Date of publication of application: **03.08.2005**
(21) Application number: 05250361.2
(22) Date of filing: 25.01.2005
(51) Int. Cl.: H01F 10/32

(54) **Magnetic resistance device**

(30) Priority: 31.01.2004 KR 2004006464
(71) Applicant: Samsung Electronics Co., Ltd., Suwon-si, Gyeonggi-do (KR)
(72) Inventor: Kim, Tae-wan, Yongin-si Gyeonggi-do (KR); Kwon, Soon-ju, Dpt. of Materials Science and Eng., Nam-gu Pohang-si Gyeongsangbuk-do (KR); Kim, Kee-won, Seocheon-gun Chungcheongnam-do (KR); Park, Sang-jin, Pyeongtaek-si Gyeonggi-do (KR)
(74) Representative: Greene, Simon Kenneth

(57) **Abstract**

Provided is a magnetic resistance device in which a pinning layer, a pinned layer, an anti-ferromagnetic layer, and a free layer are sequentially formed, and the free layer is formed of an intermetallic compound. The magnetic resistance device provides a high MR ratio, thereby increasing a sensitivity margin.

## Description

The present invention relates to a magnetic resistance device, and more particularly, to a magnetic resistance device whose free layer or pinned layer uses an inter-metallic compound or an inter-metallic alloy.

Due to the rapid development of super thin film deposition in a high-vacuum state, it is now possible to grow and manufacture a magnetic thin film having a thickness of only a few nanometers, which is on the order of the range of spin-spin interaction. Accordingly, many phenomena that are not observed in bulk magnetic materials have been observed and are on the verge of being utilized in various technology such as electrical household appliances and industrial parts such as magnetic recording heads for recording information on a super high-density information storage medium or a magnetic random access memory (MRAM).

In a magnetic resistance device, electrical resistance varies according to magnetic energy. In the case of a magnetic resistance head, which detects information recorded on an information storage medium such as hard disk drive (HDD), a giant magnetic resistance (GMR) head and a tunnel magnetic resistance (TMR) head are widely used.

A GMR structure is generally formed of a series of a ferromagnetic body (pinned layer) / a metallic nonmagnetic body (spacer layer) / a ferromagnetic body (free layer). This structure utilizes the principle that when an electron passes through the ferromagnetic layers, a resistance value varies according to the spin arrangement of the two magnetic layers. This phenomenon can be explained by spin-dependent scattering. Also, a TMR structure is generally formed of a series of a ferromagnetic body / an insulating layer (tunnel barrier layer) / a ferromagnetic body. In this structure, the insulating layer is interposed between two ferromagnetic bodies so that a tunneling current varies according to the relative magnetic directions of the ferromagnetic bodies. In the case of an MRAM that uses the GMR phenomenon, a voltage difference is not great because the variation in resistance according to magnetic direction is relatively small.

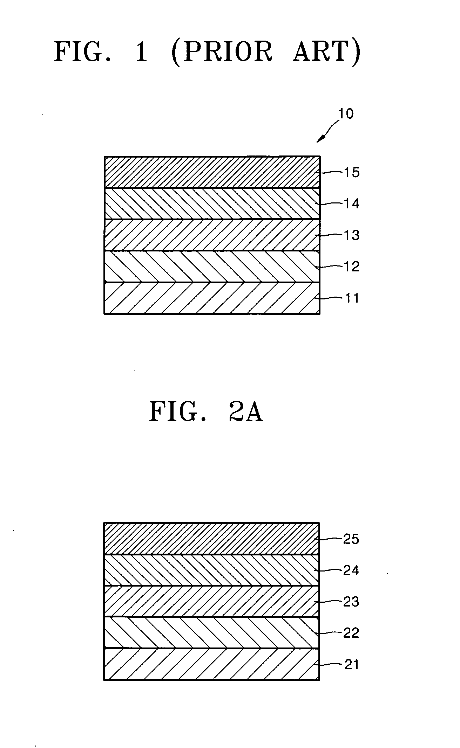

FIG. 1 is a cross-sectional view illustrating a conventional TMR device 10. An anti-ferromagnetic layer 12 that fixes electron spin of a first ferromagnetic layer 13 is formed on a substrate 11, and the first ferromagnetic layer 13 which is a pinned layer, a tunnel barrier layer 14, and a second ferromagnetic layer 15 which is a free layer, are sequentially formed on the anti-ferromagnetic layer 12. The conventional TMR device 10 uses a principle that a tunneling current varies according to the relative magnetic direction of the ferromagnetic layers. Here, the anti-ferromagnetic layer 12 (pinning layer) that fixes the spin direction of the first ferromagnetic layer 13 (pinned layer) is formed of anti-ferromagnetic material.

If a current is applied when the magnetic spin of the first ferromagnetic layer 13 (pinned layer) is opposite to the magnetic spin direction of the second ferromagnetic layer 15 (free layer), only a small amount of current flows through a barrier layer due to the high magnetic resistance of the TMR device. Conversely, when the magnetic spin direction of the pinned layer is the same as that of the free layer, a larger current flows because the magnetic resistance is low. At this time, a magnetoresistive (MR) ratio is given by Formula 1:$\text{[Formula 1]} \text{MRratio} \text{=} \frac{\text{highMR} \text{-} \text{lowMR}}{\text{lowMR}} \text{=} \frac{\text{2} {\text{P}}_{\text{1}} {\text{P}}_{\text{2}}}{\text{1 -} {\text{P}}_{\text{1}} {\text{P}}_{\text{2}}} \text{,}$ where P₁ represents spin polarization of the pinned layer 13 and P₂ represents spin polarization of the free layer 15. When the MR ratio is high, a high-performance magnetic resistance device can be realized because the spins of the pinned layer 13 and of the free layer 15 are clearly distinguished.

As described above, a high MR ratio is very important for improving the performance of a magnetic resistance device. In conventional magnetic resistance devices, CoFe or NiFe is used as a magnetic material for ferromagnetic layers such as the free layer and the pinned layer. However, in order to manufacture more highly integrated and higher performance devices, a magnetic resistance material having a higher MR ratio is required.

According to an aspect of the present invention, there is provided a magnetic resistance device in which a pinning layer, a pinned layer, an anti-ferromagnetic layer, and a free layer are sequentially formed, and the free layer is formed of an intermetallic compound.

Here, one or both of the pinned layer and the pinning layer can also be formed of an intermetallic compound.

The intermetallic compound preferably has a general structural formula of X₂YZ, where X is Co or a metal selected from the Cu group, Y is selected from the group consisting of Mn, V, Ti, Ni, and Hf, and Z is, as a material of the 3A or 4A family, an anti-ferromagnetic material selected from the group consisting of AI, Si, Ga, Ge, Sn and Sb.

The intermetallic compound preferably includes at least a material selected from the group consisting of PtMnSb, NiMnSb, CuMnSb, PdMnSb, PtFeSb, PtCrSb, and PhMnSb.

According to another aspect of the present invention, there is provided a magnetic resistance device in which a pinning layer, a pinned layer, an anti-ferromagnetic layer, and a free layer are sequentially formed, and the pinned layer is formed of an intermetallic compound.

The present invention aims to provide a magnetic resistance device having a high MR ratio that uses a magnetic resistance material that has not been used in conventional magnetic resistance devices.

The layers that are "sequentially formed" are arranged in that order on top of one another.

The above and other features and advantages of the present invention will become more apparent by describing in detail exemplary embodiments thereof with reference to the attached drawings in which:
FIG. 1 is a cross-sectional view illustrating a conventional magnetic resistance device;
FIGS. 2a and 2b are cross-sectional views illustrating magnetic resistance devices according to first and second embodiments of the present invention, respectively;
FIG. 3 is schematic drawing showing a crystal structure of an intermetallic compound;
FIG. 4 is a schematic drawing illustrating a method of forming an intermetallic compound in a magnetic resistance device according to the present invention;
FIG. 5a is a graph showing x-ray diffraction data of a magnetic resistance device according to the first embodiment of the present invention;
FIGS. 5b and 5c are TEM images of an intermetallic compound layer according to an embodiment of the present invention; and
FIG. 5d is a graph of measured MR value versus magnetic field strength applied to the magnetic resistance device according to the first embodiment of the present invention.

The present invention will now be described more fully with reference to the accompanying drawings in which exemplary embodiments of the invention are shown.

FIG. 2a is a cross-sectional view of a magnetic resistance device according to a first embodiment of the present invention.

Referring to FIG. 2a, a pinning layer 22, a pinned layer 23, a tunnel barrier layer 24, and a free layer 25 are sequentially formed on a substrate 21. The magnetic resistance device has the same basic structure as a conventional tunneling magnetic resistance device. However, according to the present invention, one or both of the pinned layer 23 and free layer 25 are formed of an intermetallic compound. Here, if the pinned layer 23 is not formed of an intermetallic compound, it can be formed of a conventional ferromagnetic material or a conventional anti-ferromagnetic material selected from an IrMn alloy, a FeMn alloy, and a NiMn alloy.

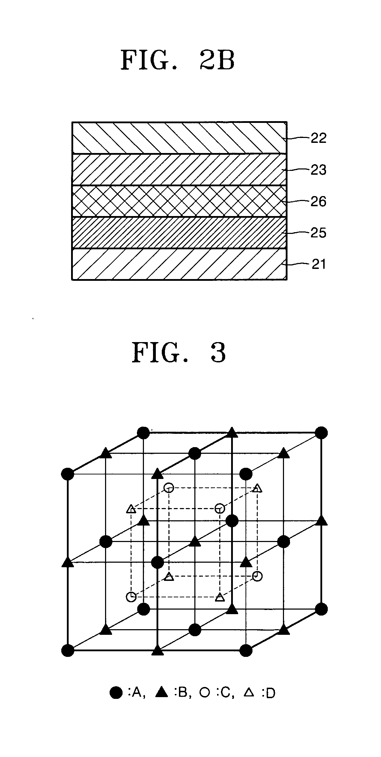

FIG. 2b is a cross-sectional view of a magnetic resistance device according to a second embodiment of the present invention.

Referring to FIG. 2b, a free layer 25, a spacer layer 26, a pinned layer 23, and a pinning layer 22 are sequentially formed on a substrate such as a Si wafer. This is the basic structure of a spin valve type GMR device. In the conventional art, the free layer 25 and the pinned layer 23 are formed of a CoFe alloy, which is a ferromagnetic material. However, it is an aspect of the present invention that the free layer 25 and the pinned layer 23 are formed of an intermetallic compound. The spacer layer 26 can be formed of an anti-ferromagnetic material such as copper, as in the conventional art. In a conventional magnetic resistance device, the pinning layer 22 is usually formed of an alloy that includes Mn, such as an IrMn alloy, an FeMn alloy, or a NiMn alloy, i.e., an anti-ferromagnetic material. The pinning layer 22 fixes the magnetic direction of the pinned layer 23. However, in the present invention, the pinning layer 22 can be formed of an intermetallic compound rather than a conventional anti-ferromagnetic material.

The operation of the magnetic resistance device having above structure is as follows. Here, the spin valve type magnetic resistance device will be described referring to FIG. 2b.

When an external magnetic field is applied to the magnetic resistance device, the magnetization direction of the free layer 25 varies with respect to the magnetic direction of the pinned layer 23. As a result, the magnetic resistance between the pinned layer 23 and the free layer 25 changes. Through such resistance variation, information magnetically recorded in an information storage device such as an MRAM or a magnetic recording medium such as a HDD is detected. Then, information recorded on a magnetic recording medium can be read by detecting the variation in magnetic resistance between the free layer 25 and the pinned layer 23. At this time, an MR ratio (amount of magnetic resistance variation to minimum device resistance) and exchange binding force (Hex: a force that fixes the magnetization direction of the pinned layer by the anti-ferromagnetic layer) must be maintained stable.

As described above, in the present invention, the pinned layer 23, the free layer 25, or the pinning layer 22 is formed of an intermetallic compound or an intermetallic alloy.

The intermetallic compound or alloy will now be described in more detail. A general structural formula of the intermetallic compound or alloy is X₂YZ, where X is a metal of the Co or the Cu group and Y is Mn, V, Ti, Ni, or Hf. Z is an anti-ferromagnetic material of the 3A or 4A family, such as AI, Si, Ga, Ge, Sn, or Sb. Examples of the intermetallic compound are Co₂MnSi, Cu₂MnAl, Cu₂MnSn, and Co₂TiSn.

FIG. 3 is a schematic drawing of a crystal having the structural formula (X₂YZ) of the intermetallic compound. Taking Co₂MnSi as an example, Co is located at sites A and B, Mn is located at site C, and Si is located at site D.

An alternative structural formula of the intermetallic compound is XYZ. Examples of intermetallic compounds having a structural formula XYZ are PtMnSb, NiMnSb, CuMnSb, PdMnSb, PtFeSb, PtCrSb, and PhMnSb.

A process of manufacturing the magnetic resistance device by depositing the intermetallic compound having the above structure can utilize a conventional process for depositing a ferromagnetic layer in the manufacture of a magnetic resistance device. However, this process of manufacturing an intermetallic compound is not efficient because of low productivity of the process and difficulty in controlling composition. For example, when depositing an intermetallic compound layer on a substrate using a sputtering process, it is difficult to make the intermetallic compound into a single target because the intermetallic compound is fragile. Therefore, it is preferable to deposit the intermetallic compound using a co-sputtering process. The co-sputtering process enables deposition of an intermetallic compound layer having a desired composition on a substrate by controlling a deposition speed after mounting object materials making an individual target in a sputtering process.

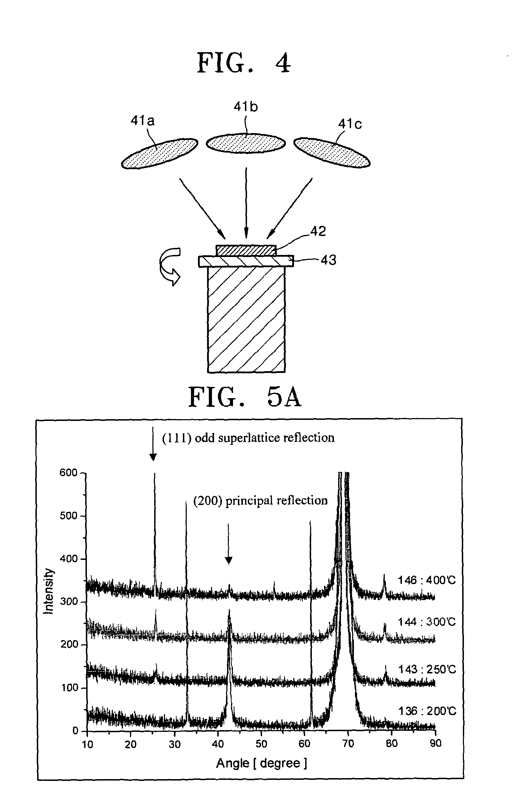

FIG. 4 is a schematic drawing illustrating deposition of an intermetallic compound on a substrate by co-sputtering. Here, taking Cu₂MnAl for instance, Cu, Mn, and Al are formed into a Cu target 41 a, an Mn target 41 b, and an Al target 41 c, respectively. A substrate 42 mounted on a substrate holder 43 is sputtered using the formed targets placed at a predetermined distance from the substrate 42. Process conditions such as pressure, temperature, and deposition speed can be controlled to produce a thin film with desired characteristics. For manufacturing the magnetic resistance device according to an embodiment of the present invention, a process pressure was approximately 10⁻³ Torr and a temperature was 200-400°C. Sputtering speeds of Cu, Mn, and AI were maintained at 83 Å/min, 44 Å/min, and 57 Å/min, respectively. Other insulating layers (tunneling barrier layer) and spacer layers can be formed by conventional deposition methods. Generally, after forming an entire magnetic resistance device in-situ, a heat treatment process can be performed.

FIG. 5a is a graph of X-ray diffraction (XRD) data of a magnetic resistance device in which the free layer 25 is formed of an intermetallic compound according to the first embodiment of the present invention. For clarity, data obtained at temperatures of about 250 °C, 300 °C, and 400 °C, is shifted by +100, +200, and +300 units, respectively, in the y-axis direction, to provide some space between the sets of data.

Referring to FIG. 5a, peaks at angles of 33°, 62°, and 68° show the characteristics of the Si substrate. A peak at an angle of 25° is the peak of a direction of 111 superlattice, and a peak at angle of 42° indicates a disorder characteristic of each of the components in the crystal structure of a direction of 200 intermetallic compound. When a superlattice peak appears, the thin magnetic film is regarded as well formed. As the temperature of the substrate is increased, the superlattice peak at an angle of about 26° grows remarkably and the disorder characteristic of the thin magnetic film at the angle of 42° decreases.

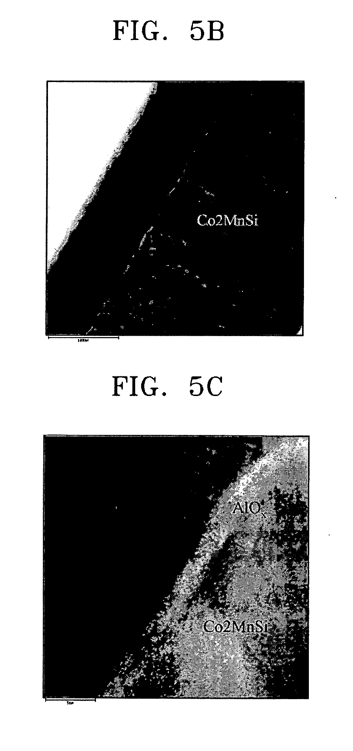

FIGS. 5b and 5c are TEM images of a cross-section of an interface between a ferromagnetic layer and an insulating layer of the magnetic resistance device according to the present invention. In the pictures, a boundary line between the Co₂MnSi layer and the AIOₓ layer is clearly visible.

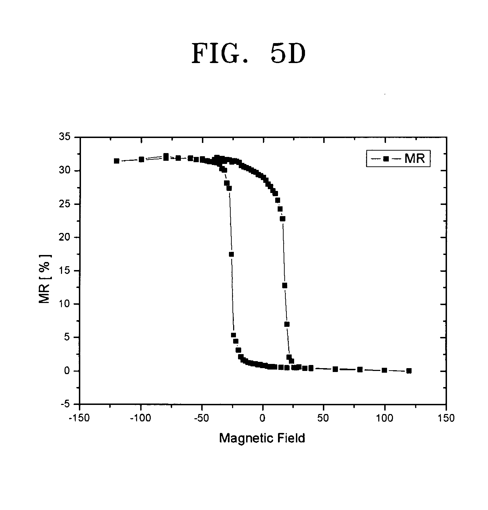

FIG. 5d is a graph showing a magnetic characteristic of the magnetic resistance device manufactured according to the present invention measured using VSM equipment. As depicted in FIG. 5d, the MR ratio of the magnetic resistance device is over 30 %.

The MR ratio is calculated by Formula 1. A ferromagnetic material generally used for a magnetic resistance device, such as NiFe, Co, or CoFe, has a polarization degree of about 40-50 % (P=0.4-0.5). However, in the case of the intermetallic compound, the polarization degree is close to 100% (P=1.0). Therefore, when a free layer and a pinned layer are both formed of an intermetallic compound, theoretically, the MR ratio goes to infinity. When only one of the free layer and the pinned layer is formed of the intermetallic compound, P₁=1, and P₂=0.5, therefore, the MR ratio is about 200%. Although these theoretical figures are based on ideal conditions and differ considerably from empirically measured values, they show that if the free layer or the pinned layer is formed of a properly deposited intermetallic compound, a very large MR ratio can be obtained.

While the present invention has been particularly shown and described with reference to exemplary embodiments thereof, it will be understood by those of ordinary skill in the art that various changes in form and details may be made therein without departing from the scope of the present invention as defined by the following claims.

According to the present invention, by using an intermetallic compound or an intermetallic alloy different from a conventional material for forming at least one of a free layer, a pinned layer, and a pinning layer, an improved MR ratio can be obtained. Accordingly, a sensitivity margin can be remarkably improved. And, in the case of a magnetic resistance head, the high MR ratio can open the door to development of higher density recording media.

## Claims

1. A magnetic resistance device in which a pinning layer, a pinned layer, an nonmagnetic layer, and a free layer are arranged in that order, and at least one of the pinning layer and the free layer is formed of an intermetallic compound.

2. The magnetoresistance device of claim 1, wherein the free layer is formed of an intermediate compound.

3. The magnetic resistance device of claim 1 or 2, wherein the pinning layer is formed of an intermetallic compound.

4. The magnetic resistance device of claim 1, 2 or 3, wherein the pinned layer is formed of an intermetallic compound.

5. The magnetic resistance device of claim 1, 2, 3 or 4, wherein the pinning layer is formed of an intermetallic compound.

6. The magnetic resistance device of any of claims 1 through 5, wherein the intermetallic compound has a general structural formula of X₂YZ, where X is a metal selected from the Co group and the Cu group, Y is selected from the group consisting of Mn, V, Ti, Ni, and Hf, and Z is, as a material of the 3A or 4A family, an anti-ferromagnetic material selected from the group consisting of AI, Si, Ga, Ge, Sn, and Sb.

7. The magnetic resistance device of any of claims 1 through 5, wherein the intermetallic compound includes at least a material selected from the group consisting of PtMnSb, NiMnSb, CuMnSb, PdMnSb, PtFeSb, PtCrSb, and PhMnSb.
